# EUROPEAN PATENT SPECIFICATION

(11) **EP 0 858 103 B1**
(45) Date of publication and mention of the grant of the patent: **14.03.2007**
(21) Application number: 98300564.6
(22) Date of filing: 27.01.1998
(51) Int. Cl.: H01L 21/3213, H01L 21/285

(54) **Method for etching Pt film of semiconductor device**
Methode, einen Platinfilm in einer Halbleiteranordnung zu ätzen
Procédé de gravure d'une couche de platine dans un dispositif semiconducteur

(30) Priority: 05.02.1997 KR 9703580; 09.06.1997 KR 9723660
(43) Date of publication of application: 12.08.1998
(73) Proprietor: SAMSUNG ELECTRONICS CO., LTD., Suwon City, Kyungki-do (KR)
(72) Inventor: Kim, Hyoun-woo, Seocho-gu, Seoul (KR); Nam, Byeong-yun, Paldal-gu, Suwon-city, Kyungki-do (KR); Ju, Byong-sun, Songpa-gu, Seoul (KR); Yoo, Won-jong, Songpa-gu, Seoul (KR)
(74) Representative: Robinson, Ian Michael

(56) References cited:
- EP-A- 0 675 548
- EP-A- 0 786 805
- US-A- 3 975 252
- US-A- 5 515 984
- US-A- 5 621 606
- YOKOYAMA S ET AL: "HIGH-TEMPERATURE ETCHING IN PZT/PT/TIN STRUCTURE BY HIGH-DENSITY ECR PLASMA" JAPANESE JOURNAL OF APPLIED PHYSICS, vol. 34, no. 2B, PART 01, 1 February 1995 (1995-02-01), pages 767-770, XP000599402

## Description

The present invention relates to a fabrication method of a semiconductor memory device, and more particularly, to a method for etching a Pt film which is used as a storage node of a capacitor of a semiconductor memory device.

In general, as the degree of integration of the semiconductor memory device becomes higher, a semiconductor memory device such as a dynamic random access memory (DRAM) requires a capacitor of high capacitance and at the same time occupying a small area. Accordingly, a trench type or cylinder type capacitor has been developed. However, the trench type or cylinder type capacitor is fabricated by a complicated process, and it is difficult to form correctly. Thus, there is a limit to realizing high capacitance and high integration, which are required for the integrated semiconductor memory device.

With a view to solving this problem, there has been provided a method for forming a capacitor, using barium strontium titanate (BST) as a dielectric of the capacitor. BST has a dielectric constant higher than that of a conventional dielectric. In the case that the capacitor is formed using a material of high dielectric constant such as BST, a Pt layer is usually used as plate and storage nodes of the capacitor. This is because the Pt is stable material which does not oxidize at the surface of a dielectric during high-temperature heat treatment for forming of a BST dielectric film. Moreover, Pt has excellent conductivity and less leakage current generated from the dielectric electrode of the capacitor than other conductive films such as Ir, Ru, or polysilicon. However, Pt is very difficult to pattern using dry etching. This is because Pt is an unreactive metal and thus it does not react with other chemicals easily. Halogen is usually used for the reactive ion etching (RIE) for etching the Pt layer, but halogen reacts weakly with Pt ions, so the Pt layer is etched not by chemical reaction, but by physical reaction of sputtering. Accordingly, in the case that the Pt layer is etched by ion sputtering, etching residues are generated, which reduce the etching slope of the Pt layer. Therefore, Pt electrodes do not have fine pattern. Also, in order to improve the low etch rate during reactive ion etching, an etching gas containing chlorine or fluorine is used.

A conventional method for etching the Pt layer, using chlorine gas as an etching gas, is disclosed in U.S.Patent No. 5,515,984 'Method for etching Pt layer', issue date May, 14, 1996. Here, chlorine and oxygen is used as an etching gas, and thus etching residues PtCl and PtO are formed on the sidewalls of an etching resist film so that the Pt layer is etched by using the etching resist film and the etching residues as an etching mask. After that the etching residues are removed by wet etching.

However, the etching residues require appropriate removal, and also the etching slope of the Pt layer is still to be improved.

US-A-3975252 discloses the technique of sputter etching titanium in a mixed halocarbon/oxygen atmosphere to provide patterning of the titanium, to be used as an etch-resistant material interposed between a resist and a relatively thick layer.

With a view to solve or reduce the above problems, it is an aim of preferred embodiments of the present invention to provide a method for etching a Pt layer of a semiconductor device, in which a semiconductor substrate where a Pt layer is formed is heated to a predetermined temperature to overetch the Pt layer, using an adhesive layer containing titanium as an etching mask on the Pt layer, to thereby improve an etching slope of the sidewall of the Pt layer.

According to an aspect of the invention, there is provided a method for etching a Pt layer of a semiconductor device, comprising steps of: forming the Pt layer on the semiconductor substrate where a bottom layer is formed; forming an adhesive layer containing Ti on the Pt layer; forming a mask layer on the adhesive layer; patterning the mask layer to form a mask pattern; patterning the adhesive layer using the mask pattern; heating the semiconductor substrate in a plasma etching apparatus; subsequently to the heating, etching the Pt layer using the mask pattern and the patterned adhesive layer, wherein the Pt layer is etched by an etching gas containing O₂ and removing the mask pattern.

A barrier layer is preferably formed on the bottom layer before the step of forming the Pt layer.

Preferably, the mask layer is composed of one or more layers including an oxide layer. Also, it is preferable that the barrier layer is formed of TiN or a material containing TiN. The bottom layer includes preferably a first insulating layer having contact holes formed on the semiconductor substrate. Here, each contact hole is preferably buried with a polysilicon plug. The etching gas containing O₂ may be O₂/Cl₂, O₂/HBr, O₂/Br₂ or O₂/Br. The etching gas is preferably at least 50% oxygen.

Preferably, the Pt layer is patterned by magnetically enhanced reactive ion etching (MERIE) method, using O₂/Cl₂ as an etching gas, where the oxygen is 50% or more of the total O₂/Cl₂ mixture.

Preferably, the mask pattern is removed by overetching past the end of etching the Pt layer.

Also, the overetching for removing the mask pattern is preferably performed by extending the etching time by 0.5 - 1.5 times as much as the etching time required to etch up to etching end point of Pt layer, and the adhesive layer and the barrier layer are patterned using Ar/Cl₂ as the etching gas.

According to embodiments of the present invention, the semiconductor substrate where the Pt layer is formed is heated to a predetermined temperature to overetch the Pt layer, using an adhesive layer containing titanium as an etching mask on the Pt layer, to thereby improve the etching slope of the sidewall of the Pt layer.

For a better understanding of the invention, and to show how embodiments of the same may be carried into effect, reference will now be made, by way of example, to the accompanying diagrammatic drawings, in which:

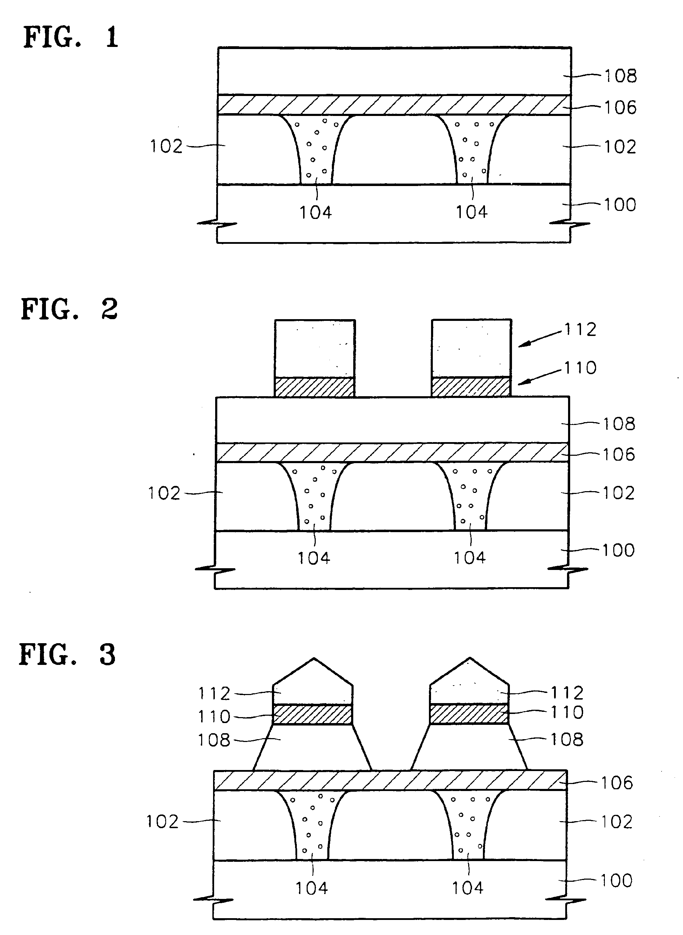

Figures 1 through 5 are sectional views illustrating a method for etching a Pt layer of a semiconductor device according to a preferred embodiment of the present invention.

A mask layer indicated in the present invention does not necessarily mean one layer. For example, the mask layer formed of an oxide layer may be formed of a plurality of layers, including an oxide layer.

Referring to Figure 1, a bottom layer is formed on a semiconductor substrate 100 where a lower structure such as a transistor(not shown) is formed. The bottom layer is a layer obtained by stacking a first insulating layer, for example, an interlayer dielectric 102, on the semiconductor substrate 100, and further performing patterning to form a contact hole, and then burying the contact hole with a polysilicon plug 104. Subsequently, the semiconductor substrate is planarized by performing a planarization process such as etchback or chemical mechanical polishing the resultant structure of the bottom layer. A barrier layer 106, for preventing deterioration of capacitor performance due to interdiffusion of the polysilicon plug 104 and the Pt layer 108, is formed on the entire surface of the resultant structure where the planarization has been performed. Here, the barrier layer 106 is formed to a thickness of 300 - 700Å (1Å = 0,1 nm), using TiN or a material containing TiN. Subsequently, Pt is deposited on the barrier layer 106 in a usual manner such as sputtering or chemical vapor deposition (CVD), to form the Pt layer 108. In an embodiment of the present invention, the Pt layer 108, being a conductive layer used as a storage node of a capacitor in a semiconductor memory device, is formed to a thickness of 2000Å ± 500Å.

Referring to Figure 2, an adhesive layer for enhancing adhesion of a mask layer to the Pt layer 108 is formed on the resultant structure where the Pt layer 108 is formed, using Ti. The adhesive layer in the present embodiment is 400 - 800Å thick. Subsequently, the mask layer of 5000Å ± 1000Å is formed on the adhesive layer, using an oxide layer. The mask layer is coated with photoresist, and a usual photolithographic process is performed to form a mask pattern 112. The mask layer, which is formed as one oxide layer in the embodiment, may be a composite layer containing the oxide layer. Then, the adhesive layer is patterned using the mask pattern 112 as an etching mask, to form an adhesive layer mask pattern 110 contacting the mask pattern 112. At this time, the adhesive layer is patterned by dry etching, for example, magnetically enhanced RIE (MERIE), using Ar/Cl₂ as an etching gas.

Referring to Figure 3, the resultant structure where the mask pattern 112 and the adhesive layer mask pattern 110 are formed is heated to 120 - 300°C, without exciting a plasma of the MERIE equipment. Subsequently, the Pt layer 108 is etched until the barrier layer 106 of a lower portion is exposed, using a mixture containing O₂ i.e., Cl₂/O₂, HBr/O₂, Br₂/O₂ or Br/O₂ as an etching gas, and the mask pattern 112 and the adhesive layer mask pattern 110 as an etching mask. At this time, it is preferable that O₂ of the mixture is at least 50%. In the present embodiment, oxygen and chlorine are mixed at 4:1. Accordingly, ions and radicals of the O₂ gas are species for sputtering the Pt layer. Also, the O₂ gas increases an etching selection ratio of the Pt layer 108 with respect to the mask pattern 112 formed of an oxide layer, and changes the Ti layer of the adhesive layer mask pattern 110 into Tiox. TiOx acts as an additional etching mask pattern during etching the Pt layer. That is, a portion of O₂ ions and radicals partially oxidize the Ti layer into the Tiox layer, to reduce erosion velocity of the mask.

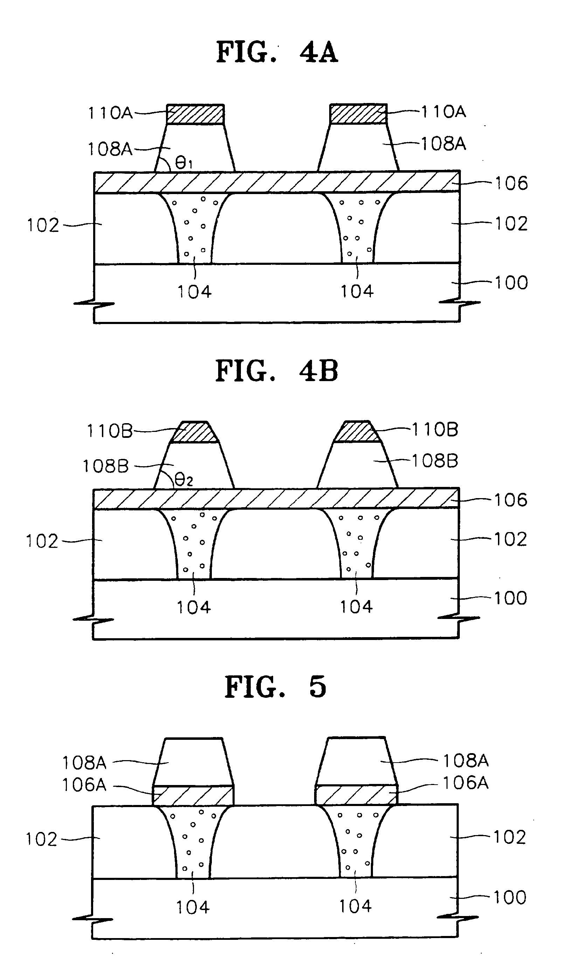

Figure 4A is a sectional view of a Pt layer 108A having an enhanced etching slope through overetching the Pt layer 108 under the same etching conditions as those of Figure 3. At this time, the mask pattern 112 erodes away completely and thus is removed during the overetching. At this time, it is preferable that the overetching is performed by extending the etching time by 0.5 - 1.5 times as much as the etching time required to expose the barrier layer 106, i.e., an etching end point as shown in Figure 3. When the etching gas of O₂/Cl₂/Ar is used, the etching slope of the Pt layer 108, having a pitch of 0.58µm and a thickness of 2000Å, is 65° or less. This is because the Pt does not react with oxygen and chlorine. However, when the Pt layer 108A is etched using an etching gas containing much oxygen, Ti forming the adhesive layer mask pattern 110 formed on the Pt layer is converted to Tiox, to act as an additional mask pattern together with an oxide layer mask pattern being the mask pattern 112. At this time, the adhesive layer mask pattern 110 of Tiox is eroded at a high temperature of 120 - 300°C by a degree equivalent to that at a room temperature. Accordingly, high temperature hastens oxidation of Ti, and thus erosion by oxygen ions or sputtering of a radical is relatively reduced, so that the mask pattern is not damaged at a high temperature. The adhesive layer mask pattern having little erosion acts as a factor for improving the etching slope of the Pt layer 108A. That is, when overetching is performed at below 120°C, the adhesive layer mask pattern 110A containing Ti begins to be rapidly eroded from an edge by sputtering. However, when the overetching is performed at a temperature of 160°C or more, the adhesive layer mask pattern 110A is not eroded, even after the mask pattern 112 is removed, and thus the etching slope of the sidewall of the Pt layer 108A is close to vertical. At this time, Ti of the adhesive layer pattern 110A is converted to Tiox more rapidly than that of the adhesive layer pattern etched at below 120°C. When the temperature of the MERIE chamber is set at 160°C and the surface temperature of the semiconductor substrate is set at 140°C, the etching slope θ1 of the Pt layer 108A is improved to be approximately 80°. The temperature of 120 - 300°C indicates the temperature of a semiconductor substrate surface. According to embodiments of the present invention, the over etching of the Pt layer 108A and the controlled etching temperature may improve the etching slope of the Pt layer.

Figure 4B is a sectional view of a semiconductor substrate after etching at 120°C or less to compare to the result of Figure 4A. At this time, the mask pattern 112 is eroded and removed, and then the edges of the adhesive layer mask pattern 110B are also eroded, which causes the sidewall slope thereof to be approximately 45°. Accordingly, when the Pt layer is etched through sputtering, the adhesive layer mask pattern 110B cannot improve the etching slope. For example, when the over etching is performed under the conditions where the chamber is at 130°C, and the semiconductor substrate surface is at 120°C, the etching slope θ2 of the Pt layer 108B is 72° or less.

Figure 5 is a sectional view of a semiconductor substrate after the mask pattern is overetched, and then the adhesive layer mask pattern 110A is removed from the Pt layer 108A, and further a barrier layer 106 under the Pt layer 108A is patterned. At this time, Ar/Cl₂ is used as the etching gas for removing the adhesive layer mask pattern 110A and patterning the barrier layer 106A. Therefore, the etching of the Pt layer 108A including the barrier layer 106A on a polysilicon plug 104 is completed.

### Example; relationship between the etching temperature and the etching slope of a Pt layer

Pt layers were overetched at etching chamber temperatures of 100°, 130°C and 160°C, respectively, and then etching slope of the sidewall of each Pt layer was measured. At this time, the Pt layer was 2000Å thick, the adhesive layer on the Pt layer was 600Å thick, and the mask pattern formed of an oxide layer was 5000Å thick. As a result, when the temperature of the etching chamber was 100°C, 130°C and 160°C, the etching slope of the sidewall of the Pt layer was 71°, 72° and 80, respectively. In the cases that the temperature of the etching chamber was 100°C and 130°C, respectively, the etching slope was not much enhanced. However, in the case that the temperature of the etching chamber was 160°C, it was remarkably enhanced.

This was because when the over etching was performed at an etching chamber temperature of 100°C, the mask pattern formed of an oxide layer is eroded and removed, and then the edges of the adhesive layer converted to Ti or TiOx under the mask pattern are continuously eroded, so that the adhesive layer was shown 600Å thick at the center, which caused the etching slope of the sidewall of the adhesive layer to be 45°. Also, when the over etching was performed at an etching chamber temperature of 130°C, the thickness of the adhesive layer on the Pt layer was 600Å at the center, however, 400Å at the edges. Accordingly, the adhesive layer was eroded too much to enhance the etching slope.

However, when the etching chamber is set at 160°C and the surface of the semiconductor substrate is at 140°C, even though the uppermost mask pattern is eroded, the adhesive layer thereunder is not eroded. That is, the adhesive layers are 600Å thick at both the edge and the center, and have sidewalls close to vertical. Accordingly, it may be possible to prevent the reduction of the etching slope of the Pt layer due to Pt atoms through sputtering while the Pt layer is anisotropically etched.

Meanwhile, when the etching was performed under the above-described conditions, the respective etch rates at 100°C, 130°C and 160°C were 395Å/min, 368Å/min and 371Å/min. When a new volatile compound is formed on the sidewall of the Pt layer to improve the etching slope, the etch rate also increases according to the temperature. However, in the case the resultant values were similar at all temperatures. Accordingly, the etch rate of the Pt layer sidewall was not improved by the chemical reaction generated from the Pt layer.

According to embodiments of the present invention, the etching slope of the Pt layer used as plate and storage nodes of the capacitor may be improved, using the fact that the erosion degree of the adhesive layer used as an additional etching mask during the Pt layer changes according to the temperature.

It should be understood that the invention is not limited to the illustrated embodiment and that many changes and modifications can be made within the scope of the invention by a person skilled in the art.

## Claims

1. A method for etching a Pt layer of a semiconductor device, comprising steps of:
forming the Pt layer (108) on the semiconductor substrate where a bottom layer (100-106) is formed;
forming an adhesive layer (110) containing Ti on the Pt layer (108);
forming a mask layer (112) on the adhesive layer (110);
patterning the mask layer (112) to form a mask pattern;
patterning the adhesive layer (110) using the mask pattern;
heating the semiconductor substrate in a plasma etching apparatus;
subsequently to the heating, etching the Pt layer (108) using the mask pattern and the patterned adhesive layer (110) wherein the Pt layer is etched by an etching gas containing O₂; and
removing the mask pattern.

2. The method of claim 1, wherein a barrier layer (106) is formed on the bottom layer before the step of forming the Pt layer (108).

3. The method of claim 2, wherein the barrier layer (106) is formed of TiN or a material containing TiN.

4. The method of claim 1, 2, or 3, wherein the mask layer consists of one or more layers.

5. The method of claim 4, wherein the one or more layers comprise one or more oxide layers.

6. The method of any of the preceding claims, wherein the semiconductor substrate is heated while no plasma is excited.

7. The method of any of the preceding claims, wherein the semiconductor substrate is heated to be within 120 - 300°C.

8. The method of any preceding claim, wherein the etching gas containing O₂ is O₂/Cl₂.

9. The method of claim 8, wherein the etching gas of O₂/Cl₂ contains at least 50% oxygen.

10. The method of any of claims 1 to 7, wherein the etching gas containing O₂ is one selected from the group consisting of HBrO₂, Br2O₂ and BrO₂.

11. The method of claim 10, wherein the etching gas of O₂/Br contains at least 50% oxygen.

12. The method of any of the preceding claims, wherein the mask pattern is removed by overetching past the end of etching the Pt layer (108).

13. The method of claim 12, wherein the overetching is performed by extending the etching time by 0.5 - 1.5% times as much as the etching time required to etch up to etching end point of Pt layer (108).

14. The method of claim 2 or any of claims 3 to 13 as dependent thereon, wherein the barrier layer (106) is patterned after removing the mask pattern.

15. The method of claim 14, wherein the barrier layer (106) is patterned by dry etching using Ar/Cl₂ as the etching gas.

## Patentansprüche

1. Verfahren zum Ätzen einer Pt-Schicht einer Halbleitervorrichtung, umfassend die nachfolgenden Schritte:
Bilden der Pt-Schicht (108) auf einem Halbleitersubstrat, an dem eine untere Schicht (100-106) gebildet ist;
Bilden einer Ti enthaltenden Adhäsivschicht (110) an der Pt-Schicht (108);
Bilden einer Maskenschicht (112) an der Adhäsivschicht (110);
Mustern der Maskenschicht (112) zum Bilden eines Maskenmusters;
Mustern der Adhäsivschicht (110) unter Verwendung des Maskenmusters;
Erwärmen des Halbleitersubstrates in einer Plasmaätzvorrichtung;
nach dem Erwärmen erfolgendes Ätzen der Pt-Schicht (108) unter Verwendung des Maskenmusters und der gemusterten Adhäsivschicht (110), wobei die Pt-Schicht durch ein O₂ enthaltendes Ätzgas geätzt wird; und
Entfernen des Maskenmusters.

2. Verfahren nach Anspruch 1, bei dem eine Barriereschicht (106) auf der unteren Schicht vor dem Schritt des Bildens der Pt-Schicht (108) gebildet wird.

3. Verfahren nach Anspruch 2, bei dem die Barriereschicht (106) aus TiN oder einem TiN enthaltenden Material gebildet wird.

4. Verfahren nach Anspruch 1, 2 oder 3, bei dem die Maskenschicht eine oder mehrere Schichten umfasst.

5. Verfahren nach Anspruch 4, bei dem die eine Schicht oder die mehreren Schichten eine oder mehrere Oxidschichten umfassen.

6. Verfahren nach einem der vorhergehenden Ansprüche, bei dem das Halbleitersubstrat ohne Erregung eines Plasmas erwärmt wird.

7. Verfahren nach einem der vorhergehenden Ansprüche, bei dem das Halbleitersubstrat auf 120 °C bis 300 °C erwärmt wird.

8. Verfahren nach einem der vorhergehenden Ansprüche, bei dem das O₂ enthaltende Ätzgas O₂/Cl₂ ist.

9. Verfahren nach Anspruch 8, bei dem das Ätzgas aus O₂/Cl₂ wenigstens 50% Sauerstoff enthält.

10. Verfahren nach einem der Ansprüche 1 bis 7, bei dem das O₂ enthaltende Ätzgas aus einer HBr/O₂, Br₂/O₂, Br/O₂ umfassenden Gruppe ausgewählt wird.

11. Verfahren nach Anspruch 10, bei dem das Ätzgas aus O₂/Br wenigstens 50% Sauerstoff enthält.

12. Verfahren nach einem der vorhergehenden Ansprüche, bei dem das Maskenmuster durch Überatzen über das Ätzende der Pt-Schicht (108) hinaus entfernt wird.

13. Verfahren nach Anspruch 12, bei dem das Überätzen durch Verlängern der Ätzzeit um das 0,5 bis 1,5-fache derjenigen Ätzzeit vorgenommen wird, die zum Ätzen bis zum Ätzendpunkt der Pt-Schicht (108) erforderlich ist.

14. Verfahren nach Anspruch 2 oder einem der Ansprüche 3 bis 13 mit Rückbezug auf Anspruch 2, bei dem die Barriereschicht (106) nach Entfernen des Maskenmusters gemustert wird.

15. Verfahren nach Anspruch 14, bei dem die Barriereschicht (106) durch Trockenätzen unter Verwendung von Ar/Cl₂ als Ätzgas gemustert wird.

## Revendications

1. Procédé pour graver une couche de Pt d'un dispositif à semi-conducteurs, comportant les étapes consistant à :
former la couche de Pt (108) sur un substrat semi-conducteur où une couche inférieure (100-106) est formée,
former une couche adhésive (110) contenant Ti sur la couche de Pt (108),
former une couche de masque (112) sur la couche adhésive (110),
mettre en forme la couche de masque (112) pour former un motif de masque,
mettre en forme la couche adhésive (110) en utilisant le motif de masque,
chauffer le substrat semi-conducteur dans un appareil de gravure au plasma,
après le chauffage, graver la couche de Pt (108) en utilisant le motif de masque et la couche adhésive mise en forme (110), la couche de Pt étant gravée par un gaz de gravure contenant O₂, et
retirer le motif de masque.

2. Procédé selon la revendication 1, dans lequel une couche de barrière (106) est formée sur la couche inférieure avant l'étape de formation de la couche de Pt (108).

3. Procédé selon la revendication 2, dans lequel la couche de barrière (106) est formée de TiN ou d'un matériau contenant TiN.

4. Procédé selon la revendication 1, 2 ou 3, dans lequel la couche de masque est constituée d'une ou plusieurs couches.

5. Procédé selon la revendication 4, dans lequel les unes ou plusieurs couches comportent une ou plusieurs couches d'oxyde.

6. Procédé selon l'une quelconque des revendications précédentes, dans lequel le substrat semi-conducteur est chauffé alors qu'aucun plasma n'est excité.

7. Procédé selon l'une quelconque des revendications précédentes, dans lequel le substrat semi-conducteur est chauffé pour être dans la plage de 120 à 300°C.

8. Procédé selon l'une quelconque des revendications précédentes, dans lequel le gaz de gravure contenant O₂ est O₂/Cl₂.

9. Procédé selon la revendication 8, dans lequel le gaz de gravure de O₂/Cl₂ contient au moins 50 % d'oxygène.

10. Procédé selon l'une quelconque des revendications 1 à 7, dans lequel le gaz de gravure contenant O₂ est un gaz sélectionné parmi le groupe constitué de HBr/O₂, Br2/O₂ et Br/O₂.

11. Procédé selon la revendication 10, dans lequel le gaz de gravure de O₂/Br contient au moins 50 % d'oxygène.

12. Procédé selon l'une quelconque des revendications précédentes, dans lequel le motif de masque est éliminé par une sur-gravure après la fin de la gravure de la couche de Pt (108).

13. Procédé selon la revendication 12, dans lequel la sur-gravure est effectuée en étendant la durée de gravure de 0,5 à 1,5 % de plus que la durée de gravure requise pour graver jusqu'au point de fin de gravure de la couche de Pt (108).

14. Procédé selon la revendication 2 ou l'une quelconque des revendications 3 à 13 lorsque dépendante de celle-ci, dans lequel la couche de barrière (106) est mise en forme après élimination du motif de masque.

15. Procédé selon la revendication 14, dans lequel la couche de barrière (106) est mise en forme par gravure en voie sèche en utilisant Ar/Cl₂ en tant que gaz de gravure.
